Europäisches Patentamt

European Patent Office

Office européen des brevets

(19)

(11) Numéro de publication : **0 210 920 B1**

(12) **FASCICULE DE BREVET EUROPÉEN**

(45) Date de publication du fascicule du brevet :
26.04.89

(51) Int. Cl.⁴ : **C 23 F 13/02**

(21) Numéro de dépôt : **86401638.1**

(22) Date de dépôt : **22.07.86**

(54) Dispositif de protection cathodique d'une structure par courant appliqué.

(30) Priorité : **23.07.85 FR 8511259**

(43) Date de publication de la demande :
**04.02.87 Bulletin 87/06**

(45) Mention de la délivrance du brevet :
**26.04.89 Bulletin 89/17**

(84) Etats contractants désignés :
**AT BE CH DE GB IT LI LU NL SE**

(56) Documents cités :
**GB—A— 1 023 731**
**US—A— 4 437 957**

(73) Titulaire : **GAZ DE FRANCE**
**23, rue Philibert Delorme**
**F-75017 Paris (FR)**

(72) Inventeur : **Lambert, Maurice Eugène**
**12 Rue de Verdun**
**F-91510 Lardy (FR)**

(74) Mandataire : **Thevenet, Jean-Bruno et al**
**Cabinet BEAU DE LOMENIE 55 rue d'Amsterdam**
**F-75008 Paris (FR)**

EP 0 210 920 B1

## Description

La présente invention a pour objet un dispositif de protection cathodique d'une structure par courant appliqué, comprenant au moins une cathode constituée par la structure à protéger, au moins un groupe d'anodes isolées de la structure et en contact avec l'électrolyte dans lequel est placée ladite structure, au moins un générateur de courant continu connecté entre la structure formant cathode et les anodes dudit groupe en contact avec l'électrolyte et au moins une électrode de référence connectée à un circuit de commande et de régulation pour ajuster la tension délivrée par ledit générateur et par là-même le courant appliqué auxdites anodes.

La protection cathodique est un moyen de protection contre la corrosion des ouvrages métalliques enterrés et immergés. Elle est obtenue en faisant débiter un générateur de courant continu entre des anodes placées dans l'électrolyte (eau ou sol) et isolées de la structure, et une cathode constituée par l'ouvrage à protéger.

Les conditions de polarisation des métaux à protéger varient suivant un grand nombre de facteurs : variation de la résistance d'isolement du revêtement s'il existe, variation de la résistivité de l'électrolyte, influence de la vitesse de l'électrolyte, formation de dépôts sur les pièces protégées etc...

Les caractéristiques du générateur de courant continu doivent donc être adaptées pour que la polarisation soit maintenue à une valeur convenable.

Dans les dispositifs connus de protection cathodique, le niveau de puissance du générateur est souvent réglé de façon manuelle. On fait alors varier la valeur de la tension de sortie par exemple à l'aide d'un auto-transformateur annulaire variable, d'un transformateur à saturation magnétique, d'un transformateur à prises multiples, ou encore de dispositifs à thyristors ou triacs.

Le niveau de puissance du générateur peut aussi être réglé automatiquement au moyen d'un asservissement. Dans ce cas, l'asservissement assure d'une part la comparaison entre un potentiel de consigne à imposer et le potentiel de l'ouvrage à protéger mesuré avec une électrode de référence placée à demeure sur cet ouvrage pour délivrer un signal de commande, et d'autre part, l'amplification de ce signal et sa transformation en courant appliqué entre les anodes et l'ouvrage à protéger dans un sens tel que ce courant tende à amener le potentiel de cet ouvrage à la valeur du potentiel de consigne.

Un tel dispositif est couramment appelé « potentiostat ».

Deux facteurs limitent toutefois l'utilisation industrielle de ce type de régulation :
— d'une part les variations des conditions de polarisation peuvent être très importantes en particulier dans les pompes, turbines, grilles filtrantes et tous appareils ou ouvrages dans lesquels la vitesse de l'électrolyte ou sa composition entre autres subissent de grandes variations. Ceci oblige à surdimensionner le potentiostat si l'on veut qu'il assure sa fonction.
— d'autre part dans certains ouvrages, tels que ceux nommés ci-dessus, la forme des pièces à protéger et la configuration du champ électrique dû au courant de protection imposent de disposer sur ce même ouvrage plusieurs séries d'anodes alimentées par des générateurs différents, mais coopérant avec un circuit électrolytique commun à l'ensemble des systèmes anodes-cathode.

Comme indiqué précédemment, dans le premier cas, le potentiostat devra être surdimensionné pour assurer sa fonction quelles que soient les conditions de polarisation.

Dans le second cas, il faudra disposer d'autant de potentiostats que de séries d'anodes correspondant aux différentes parties de la machine à protéger. En raison à la fois de la continuité électrique des différentes parties métalliques de l'ouvrage à protéger, et du milieu électrolytique commun constitué par le liquide véhiculé, des interactions se produiront entre les différents potentiostats entraînant une instabilité du potentiel et un phénomène d'oscillation du courant de sortie des potentiostats.

La présente invention vise précisément à remédier aux inconvénients précités et à permettre l'adaptation automatique d'un générateur de courant de protection cathodique aux variations des conditions de polarisation sans qu'il soit nécessaire de surdimensionner le système et tout en réduisant l'influence des interférences sur le potentiel de l'ouvrage à protéger qui sont dues à la présence d'un électrolyte commun à différents circuits anodes-cathode.

L'invention vise également à réaliser un système pouvant s'appliquer également à au moins deux cathodes distinctes polarisées par au moins un générateur et une anode chacune, dont les champs électriques des ensembles anode-redresseur-cathode interfèrent.

Ces buts sont atteints grâce à un dispositif de protection cathodique d'une structure par courant appliqué du type mentionné en tête de la description, qui, conformément à l'invention, comprend des moyens pour mettre en service de façon cyclique le circuit de commande et de régulation d'un générateur, des moyens de lecture du potentiel fourni par l'électrode de référence et de calcul de la différence de potentiel entre la structure protégée et le potentiel d'électrode lu, des moyens de comparaison de la différence de potentiel calculée d'une part avec un premier potentiel de référence constituant un seuil haut et d'autre part avec un second potentiel de référence constituant un seuil bas, et des moyens pour ajuster par pas d'une valeur prédéterminée la valeur absolue de la tension de sortie délivrée par le générateur dans le sens d'un accroissement si la différence de potentiel calculée est moins négative que celle du seuil haut ou dans le sens d'une réduction si la différence de potentiel calculée est plus négative que celle du seuil bas.

Selon une caractéristique particulière, les moyens de mise en service de façon cyclique du circuit de commande et de régulation d'un générateur comprennent une horloge dont la fréquence des cycles est adaptée à la durée de la polarisation électrochimique.

Selon une autre caractéristique particulière, les moyens de mise en service de façon cyclique du circuit de commande et de régulation d'un générateur comprennent un contact temporisé dont la fermeture est liée au fonctionnement de la structure à protéger.

Un circuit de commande et de régulation d'un générateur peut ainsi être commandé de façon cyclique à l'aide d'un relais asservi à l'état de la machine comprenant la structure à protéger.

Ceci permet en particulier d'effectuer chaque fois un réajustement du courant appliqué aux anodes dans des conditions similaires, par exemple à la mise en marche de la machine ou, en fonctionnement, pour un état de marche déterminé correspondant à un état donné de conditions de polarisation.

Avantageusement, le dispositif comprend au moins deux électrodes de référence connectées au circuit de commande et de régulation associé au même générateur et au même groupe d'anodes et les moyens de lecture de potentiel de référence comprennent un circuit comparateur pour déterminer à chaque cycle l'électrode de référence la plus électro-négative et choisir pour le calcul de la différence de potentiel calculée le potentiel le plus négatif.

Dans ce cas, le dispositif comprend en outre des moyens de signalisation lorsque la différence entre les potentiels des électrodes de référence dépasse une valeur prédéterminée.

Selon une application particulière de l'invention, le dispositif comprend plusieurs groupes d'anodes réparties en diverses zones de la structure à protéger, isolées de celle-ci et en contact avec l'électrolyte ; des générateurs de courant continu en nombre p égal au nombre p de groupes d'anodes, chaque générateur étant connecté à un groupe d'anodes ; des groupes d'électrodes de référence disposées au voisinage des différents groupes d'anodes et connectées aux différents circuits de commande et de régulation pour ajuster la tension délivrée par chacun des générateurs associés aux différents groupes d'anodes ; des moyens pour mettre en service de façon cyclique les différents circuits de commande et de régulation et des moyens pour affecter à chaque circuit de commande et de régulation des premier et second potentiels de référence constituant des seuils haut et bas et pour ajuster par pas d'une valeur prédéterminée la valeur de la tension de sortie délivrée par chaque générateur associé à un groupe d'anodes en fonction de la valeur de la différence de potentiel calculée par rapport aux seuils haut et bas.

Avantageusement, les électrodes de référence sont constituées par des électrodes comprenant un réservoir d'un électrolyte saturé de manière à présenter des propriétés maintenues constantes dans le temps quelles que soient les variations de la composition de l'électrolyte dans lequel est placée la structure à protéger.

D'autres caractéristiques et avantages de l'invention ressortiront de la description suivante d'un mode particulier de réalisation de l'invention, en référence au dessin annexé, sur lequel :

— la figure 1 est un schéma bloc d'un circuit de commande et de régulation inclus dans un dispositif conforme à l'invention,

— la figure 2 représente une vue schématique d'un exemple de structure à laquelle peut s'appliquer l'invention,

— la figure 3 est un organigramme montrant le fonctionnement séquentiel d'un circuit de commande et de régulation selon l'invention, et

— la figure 4 est un schéma d'un générateur de courant continu pouvant être utilisé dans le cadre de l'invention.

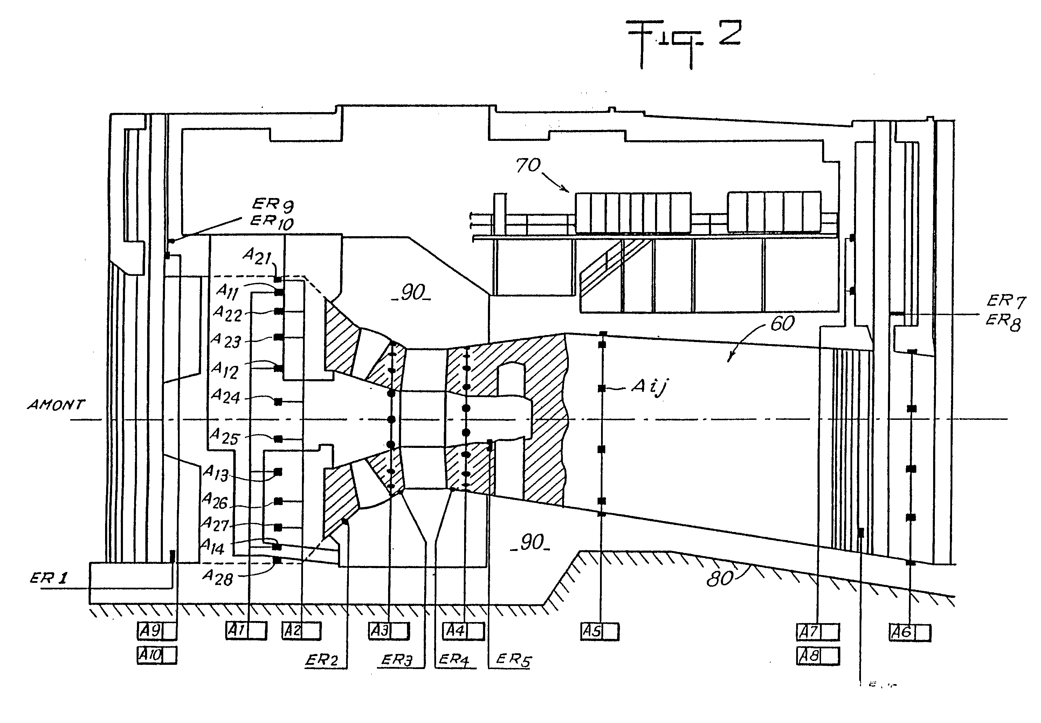

On voit sur la figure 2 une structure métallique susceptible de jouer le rôle de cathode et pouvant ainsi faire l'objet d'une protection cathodique. Il s'agit à titre d'exemple d'une turbine 60 dite « au fil de l'eau » placée dans un milieu aqueux 90 qui peut être un milieu marin et entourée d'une infrastructure 80. L'invention est cependant applicable à de nombreux autres types de structures métalliques susceptibles d'être immergées ou enterrées, par exemple des alternateurs, des conduites métalliques, des vannes ou des coques de navires.

Plusieurs groupes d'anodes $A_1$ à $A_{10}$ sont disposés en diverses zones de la structure 60 à protéger. Chaque groupe d'anodes $A_i$ (i étant un entier qui dans l'exemple considéré est compris entre 1 et 10) comprend plusieurs anodes $A_{ij}$ (avec j compris entre 1 et par exemple 12) alimentées à partir d'un même générateur de courant. La figure 2 ne montre que d'une façon globale les blocs d'alimentation 70 des divers groupes d'anodes. On voit sur la figure 2 les anodes $A_{11}$, $A_{12}$, $A_{13}$, $A_{14}$ du groupe $A_1$ et les anodes $A_{21}$, $A_{22}$, $A_{23}$, $A_{24}$, $A_{25}$, $A_{26}$, $A_{27}$, $A_{28}$ du groupe $A_2$.

Chaque anode $A_{ij}$ est isolée de la structure métallique 60 qui joue elle-même le rôle de cathode et se trouve en contact avec l'électrolyte 90. Les anodes $A_{ij}$ peuvent être placées en relief sur la structure métallique 60, avec interposition d'un élément d'isolation entre la structure 60 et chaque anode $A_{ij}$. Les anodes $A_{ij}$ peuvent également être encastrées et être disposées alors non pas directement sur la structure métallique 60 mais dans le béton du génie civil de l'ouvrage à protéger. De telles anodes sont alors constituées chacune d'une pièce métallique encastrée dans une semelle en matière plastique et munie d'une connexion étanche, l'ensemble étant placé dans un logement prévu à cet effet.

Les anodes $A_{ij}$ d'un groupe $A_i$ sont placées de manière à assurer une bonne répartition du champ électrique au sein de l'électrolyte 90. Les différents groupes d'anodes $A_1$ à $A_{10}$ correspondent à différentes parties de la machine à protéger par exemple à différents sous-ensembles de la structure métallique d'un groupe turboalternateur comme représenté sur la figure 2.

Un groupe d'au moins deux électrodes de référence est disposé au voisinage de chaque groupe d'anodes · On a repéré sur la figure 2 par les références ER1 à ER10 les paires d'électrodes de référence associées aux groupes d'anodes $A_1$ à $A_{10}$ respectivement.

On sait que dans les milieux dont la composition varie fortement au cours du temps, le potentiel des électrodes de référence n'est pas stable car il dépend de la concentration de l'ion réagissant dans le processus de formation du potentiel d'électrode (par exemple l'ion chlore pour les électrodes Mercure/Calomel ou celles à l'Argent/chlorure d'Argent).

C'est la raison pour laquelle en remplacement des électrodes de référence standard on peut utiliser des électrodes de référence munies d'un réservoir rempli de cristaux de sel réagissant qui saturent la solution dans laquelle baigne l'électrode. La liaison entre la solution saturée et le milieu extérieur s'effectuant à travers un filtre poreux, la durée pendant laquelle l'électrode donne une indication stable dépend du taux de diffusion du filtre poreux et de la capacité en sel du réservoir de l'électrode. On peut toutefois par ce moyen fabriquer des électrodes dont le fonctionnement est assuré pendant plus d'un an.

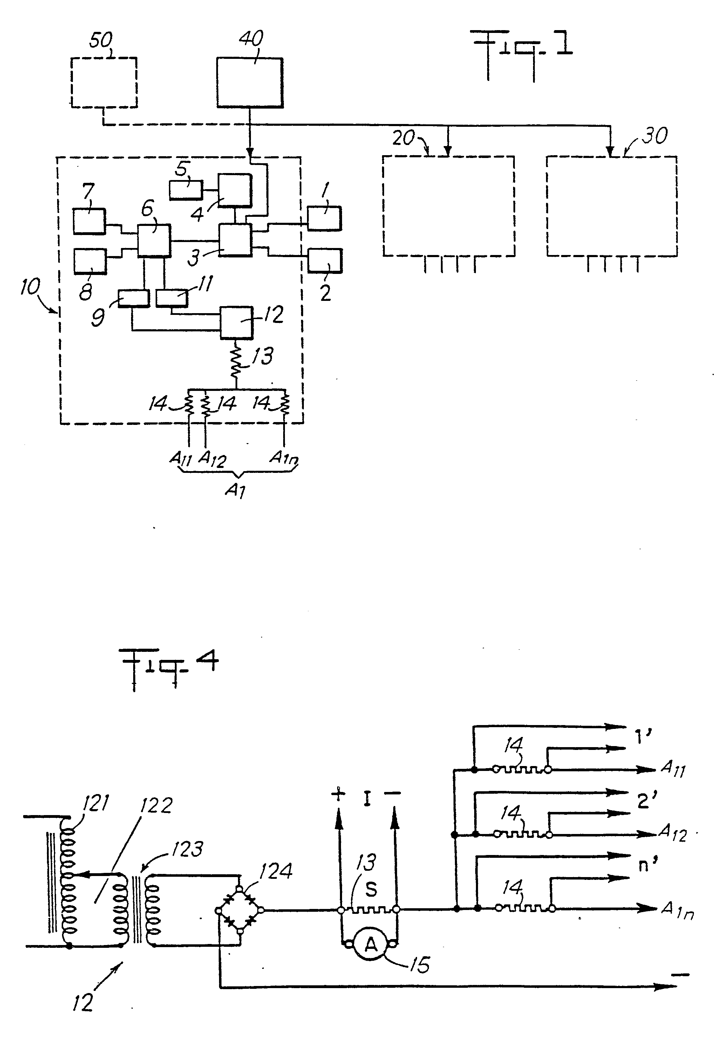

On se reportera maintenant à la figure 1 qui montre schématiquement un ensemble de circuits de commande et de régulation 10, 20, 30.... pouvant être utilisés en combinaison avec les groupes d'anodes $A_1$, $A_2$, $A_3$,... et les ensembles d'électrodes de référence ER1, ER2, ER3,... de la figure 2.

On rappelle que dans un système de protection de type cathodique par courant appliqué, on fait circuler un courant continu entre des anodes plongées dans le sol ou le liquide entourant la structure métallique à protéger et ladite structure qui constitue une cathode. Il est important de maintenir la valeur du courant utilisé dans une plage de valeurs donnée. En effet, une valeur de courant trop faible n'est pas à même d'empêcher la corrosion de se poursuivre tandis qu'un courant trop important conduit à un gaspillage d'énergie électrique. Les électrodes de référence permettent précisément, par la mesure de la différence de potentiel existant entre celles-ci dont le potentiel est supposé stable et la structure à protéger dont le potentiel est variable, de surveiller si le courant appliqué est correct, trop élevé ou trop faible.

Dans les systèmes d'asservissement automatique connus, les signaux provenant des électrodes de référence sont amplifiés et servent à actionner des dispositifs qui modifient le courant appliqué continu provenant d'un générateur afin de maintenir en permanence le courant appliqué dans une plage de valeurs prédéterminées.

Comme cela a été indiqué plus haut, l'utilisation d'un asservissement à faible constante de temps assurant la constance du potentiel de l'ouvrage à protéger à une valeur égale ou inférieure au potentiel maximal de protection cathodique conduit à installer un générateur de courant surdimensionné pour répondre à la demande maximale de courant, du fait que la demande de courant varie considérablement avec la vitesse de l'électrolyte en contact avec le métal à protéger, laquelle vitesse est non négligeable lorsqu'il s'agit par exemple d'un ouvrage en eau de mer agitée, et du fait que la formation de dépôts calcomagnésiens sur l'ouvrage à protéger est difficile à contrôler.

Dans le cas où plusieurs circuits anodescathode sont disposés sur une même structure, un asservissement en continu entraîne de plus des oscillations du courant délivré par les générateurs.

C'est la raison pour laquelle chaque circuit de commande et de régulation 10, 20, 30 selon l'invention est commandé de façon cyclique pour adapter par pas en cours d'utilisation le courant de manière à amener par étapes le potentiel de l'ouvrage à protéger à l'intérieur d'une gamme de valeurs prédéterminées.

On décrira ci-après le circuit de commande 10 associé au premier groupe d'anodes $A_1$ et à l'ensemble ER1 d'électrodes de référence 1,2 placées sur la partie de la machine à protéger concernée par le générateur 12 délivrant un courant aux anodes $A_{11}$ à $A_{1n}$ du groupe $A_1$.

Les électrodes de référence 1 et 2 sont reliées à un comparateur 3 qui mesure la différence de potentiel entre les électrodes 1,2 et sélectionne l'électrode 1 ou 2 la plus électro-négative pour la commande de la régulation. Une seule électrode de référence 1 ou 2 est ainsi utilisée pour la commande de la régulation, mais la deuxième électrode de référence permet d'effectuer à chaque fois un contrôle des électrodes de référence 1,2 entre elles à l'aide du comparateur 3. Lorsque l'écart de potentiel mesuré par le comparateur 3 dépasse un seuil prédéterminé fixé par le circuit de seuil 4 relié au comparateur 3, une alarme 5 est déclenchée pour indiquer que l'une au moins des électrodes de référence 1,2 est déficiente.

Le potentiel de l'électrode de référence 1 ou 2 sélectionnée par le comparateur 3 est appliqué à un second comparateur 6 qui effectue une double comparaison entre d'une part le potentiel fourni par le comparateur 3 et d'autre part des potentiels de valeur $E_H$ et $E_B$ constituant des seuils haut et bas et engendrés par des circuits 7 et 8 reliés au comparateur 6. Les seuils haut et bas $E_H$ et $E_B$ sont engendrés au moyen d'une tension de référence si l'on utilise un comparateur analogique 6 ou inscrits dans des mémoires si le comparateur 6 est de type numérique.

Si la valeur du potentiel fourni par le comparateur 3 se trouve située entre les valeurs $E_H$ et $E_B$ le comparateur 6 ne délivre aucun signal aux relais 9 ou 11 chargés de commander la variation de la tension de sortie du générateur 12. Si la

valeur fournie par le comparateur 3 est plus négative que celle du seuil bas $E_B$, la polarisation est excessive et un signal d'une durée fixe est appliqué au relais 11 qui commande une réduction d'une valeur fixée à l'avance (par exemple 0,2v) de la tension délivrée par le générateur 12.

Si la valeur fournie par le comparateur 3 est moins négative que celle du seuil haut $E_H$, la polarisation est insuffisante et le relais 9 commande une augmentation de valeur fixe prédéterminée (par exemple également de 0,2v) de la tension délivrée par le générateur 12.

Chaque cycle tel que décrit ci-dessus est initié soit par une horloge 40 dont la fréquence des cycles est adaptée à la durée de la polarisation électrochimique (cette fréquence pouvant être par exemple de deux cycles par jour), soit par un contact temporisé 50 en relation avec le fonctionnement de l'organe 60 à protéger. Le contact temporisé 50 peut ainsi se déclencher à chaque mise en marche de la machine.

Comme représenté sur la figure 4, un générateur de courant continu 12 peut comprendre par exemple un auto-transformateur variable 121 alimentant par l'intermédiaire d'un transformateur 123 un circuit redresseur 124 qui est lui-même relié à un groupe d'anodes $A_1$. La mesure du courant I délivré par le circuit redresseur 124 est effectuée à l'aide d'un shunt 13 aux bornes duquel est connecté un ampèremètre 15.

Le rapport de transformation de l'auto-transformateur 121 peut être commandé par un système électro-mécanique avec un moteur 122 ou électronique à partir d'un micro-calculateur gérant le circuit de commande 10 afin de pouvoir imposer un courant fixé par le micro-calculateur à partir des informations fournies par les étapes de comparaison 3 et 6.

Des résistances 14 connectées en série entre le générateur 12 et les anodes $A_{11}$ à $A_{1n}$ respectivement permettent de prélever des signaux représentatifs du courant appliqué à chaque anode $A_{11}$ à $A_{1n}$ du même groupe $A_1$ à partir du générateur 12.

Un dispositif de limitation de surintensité peut être associé au circuit de commande 10. La valeur du courant maximum que doit fournir le redresseur 124 étant mise en mémoire, une comparaison entre la valeur de courant maximum mémorisée et la valeur fournie par l'ampèremètre 15 ou les appareils de mesure connectés aux bornes des résistances 14 est effectuée à chaque cycle de réajustement du courant pendant la commande de la variation de l'auto-transformateur variable 121. Cette comparaison entraîne un ordre d'arrêt du mouvement du curseur de l'auto-transformateur 121 ou un mouvement inverse dont l'action limite ou réduit la tension appliquée par le redresseur 124 à une valeur telle que lors d'une modification par pas de la valeur du courant délivrée par le générateur 12 le courant ne dépasse pas le seuil prédéterminé de limitation de surintensité.

Un intérêt essentiel du système de commande selon l'invention réside dans l'ajustement pas à pas effectué au cours du temps des caractéristiques des redresseurs aux variations des conditions de polarisation cathodique, la sécurité du système étant assurée par le choix d'une électrode de référence parmi plusieurs 1,2 situées au voisinage l'une de l'autre.

Cet ajustement pas à pas supprime la nécessité d'un contrôle et d'un réglage manuels. Par ailleurs, l'action cyclique permet d'intervenir sur plusieurs générateurs de protection cathodique commandant des groupes d'anodes $A_1$ à $A_{10}$ susceptibles de s'influencer mutuellement.

En procédant à des itérations successives et en choisissant l'ordre séquentiel de commande pas à pas des circuits de commande 10, 20, 30 ... associés aux différents groupes d'anodes $A_1$, $A_2$, $A_3$..., il est possible de réduire les interférences des différents circuits entre eux sur le potentiel de l'ouvrage à protéger.

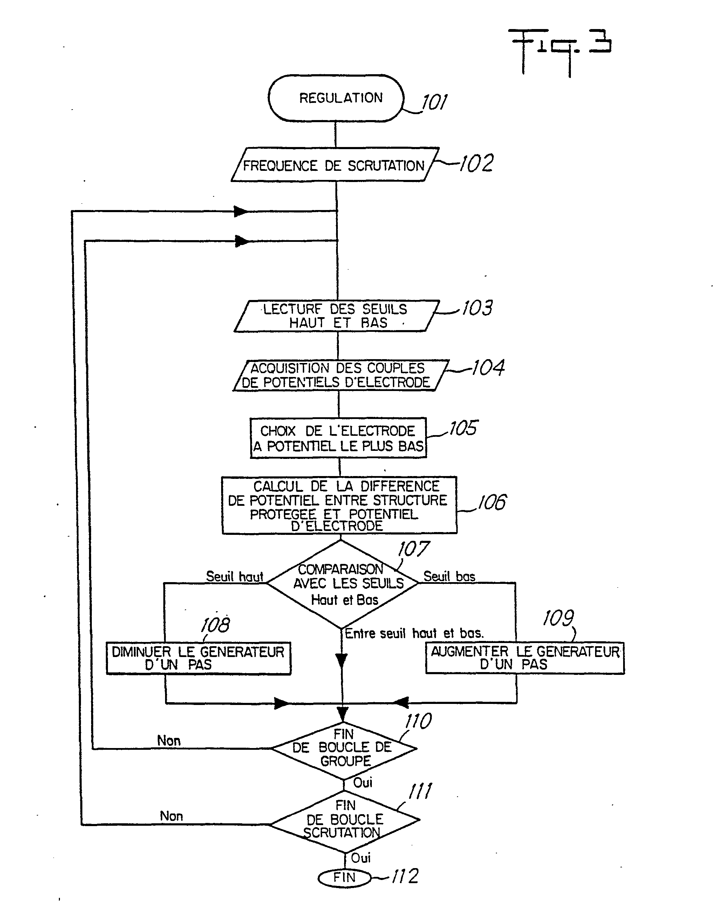

On a représenté sur la figure 3 un organigramme simplifié montrant le schéma fonctionnel de la régulation d'un dispositif de protection cathodique selon l'invention mettant en œuvre plusieurs groupes $A_i$ d'anodes $A_{ij}$.

L'étape 101 correspond à l'initialisation de la régulation. L'étape 102 définit une fréquence de scrutation qui conditionne le comportement cyclique et doit être adaptée aux conditions de fonctionnement. Cette fréquence de scrutation correspond à la fréquence de l'horloge 40 de la figure 1 et peut être de l'ordre de un ou deux cycles par jour. L'initialisation de la régulation peut toutefois être également commandée par le relais temporisé 50 actionné par exemple à la mise en marche de la machine ou à la mise en œuvre d'une opération particulière, telle que par exemple une opération de pompage, qui assure que la séquence d'ajustement du courant sera toujours effectuée dans des conditions similaires de polarisation.

Le schéma de régulation comprend une série de boucles de scrutation dont le nombre est fonction de la fréquence de scrutation, avec un test 111 de fin de boucle de scrutation qui détermine la fin 112 d'un cycle de régulation.

Pour chaque boucle de scrutation, une ou plusieurs boucles de groupe sont effectuées selon que le dispositif de protection cathodique comprend un ou plusieurs groupes d'anodes.

Pour chaque boucle de groupe correspondant à un groupe d'anodes $A_i$, l'étape 103 correspond à la lecture des seuils haut et bas $EH_i$ et $EB_i$ qui définissent une fourchette de potentiel adaptée aux conditions particulières de dépolarisation au voisinage du groupe d'électrodes considéré. L'étape 104 correspond à l'acquisition des couples de potentiels d'électrode $ELi1$ et $ELi2$ correspondant aux deux électrodes de référence 1, 2 associées au circuit de commande du groupe considéré $A_i$.

L'étape 105 d'une boucle de groupe correspond au choix de l'électrode 1 ou 2 à potentiel le plus bas par comparaison des valeurs de potentiels d'électrodes de référence $ELi1$ et $ELi2$. On n'a pas représenté sur l'organigramme l'étape facultative consistant à comparer la valeur absolue de la différence ELi1-ELi2 à un seuil déterminé et à déclencher une alarme en cas de dépassement de ce seuil (circuits 4 et 5 de la figure 1).

L'étape 106 d'une boucle de groupe correspond au calcul de la différence de potentiel entre la structure à protéger 60 et le potentiel de l'électrode de référence retenue à l'étape 105.

L'étape 107 consiste en un double test avec une comparaison de la valeur calculée à l'étape 106 avec d'une part le seuil haut EHi et d'autre part le seuil bas EBi lus à l'étape 103. Si la valeur de différence de potentiel calculée est supérieure au seuil haut EHi, l'étape suivante est l'étape 108 consistant à diminuer d'un pas la valeur du courant délivré par le générateur de courant 12 de la boucle considérée.

Si la valeur de différence de potentiel calculée est inférieure au seuil bas EBi, l'étape suivante est l'étape 109 consistant à augmenter d'un pas la valeur du courant délivré par le générateur de courant 12 de la boucle considérée. Après l'étape 108 ou l'étape 109, ou si la valeur de différence de potentiel calculée est comprise entre les seuils bas et haut EBi et EHi, le test de fin de boucle de groupe 110 est exécuté.

## Revendications

1. Dispositif de protection cathodique d'une structure par courant appliqué, comprenant au moins une cathode constituée par la structure à protéger (60), au moins un groupe ($A_1$) d'anodes ($A_{11}$, $A_{12}$, $A_{1n}$) isolées de la structure (60) et en contact avec l'électrolyte (90) dans lequel est placée ladite structure (60), au moins un générateur de courant continu (12) connecté entre la structure (60) formant cathode et les anodes ($A_{11}$, ...$A_{1n}$) dudit groupe ($A_1$) en contact avec l'électrolyte (90) et au moins une électrode de référence (1) connectée à un circuit de commande et de régulation (10) pour ajuster la tension délivrée par ledit générateur (12) et par là-même le courant appliqué auxdites anodes ($A_{11}$, ...$A_{1n}$), caractérisé en ce qu'il comprend des moyens (40, 50) pour mettre en service de façon cyclique le circuit de commande et de régulation (10) d'un générateur (12), des moyens (3 ; 105, 106) de lecture du potentiel ($EL11$) fourni par l'électrode de référence (1) et de calcul de la différence de potentiel entre la structure protégée (60) et le potentiel d'électrode lu, des moyens (6 ; 107) de comparaison de la différence de potentiel calculée d'une part avec un premier potentiel de référence (EH) constituant un seuil haut et d'autre part avec un second potentiel de référence (EB) constituant un seuil bas, et des moyens (9, 11 ; 108, 109) pour ajuster par pas d'une valeur prédéterminée la valeur absolue de la tension de sortie délivrée par le générateur (12) dans le sens d'un accroissement si la différence de potentiel calculée est moins négative que celle du seuil haut (EH) ou dans le sens d'une réduction si la différence de potentiel calculée est plus négative que celle du seuil bas (EB).

2. Dispositif selon la revendication 1, caractérisé en ce qu'il comprend au moins deux électrodes de référence (1, 2) connectées au circuit de commande et de régulation associé au même générateur (12) et au même groupe d'anodes ($A_{11}$, ...$A_{1n}$) et en ce que les moyens (3 ; 105, 106) de lecture de potentiel de référence comprennent un circuit comparateur (3 ; 105) pour déterminer à chaque cycle l'électrode de référence (1 ou 2) la plus électro-négative et choisir pour le calcul de la différence de potentiel calculée le potentiel ($EL11$ ou $EL12$) le plus négatif.

3. Dispositif selon la revendication 2, caractérisé en ce qu'il comprend en outre des moyens (4, 5) de signalisation lorsque la différence entre les potentiels ($EL11$, $EL12$) des électrodes de référence (1, 2) dépasse une valeur prédéterminée.

4. Dispositif selon l'une quelconque des revendications 1 à 3, caractérisé en ce que les moyens (40, 50) de mise en service de façon cyclique du circuit de commande et de régulation d'un générateur (12) comprennent un contact temporisé (50) dont la fermeture est liée au fonctionnement de la structure (60) à protéger.

5. Dispositif selon l'une quelconque des revendications 1 à 3, caractérisé en ce que les moyens (40, 50) de mise en service de façon cyclique du circuit de commande et de régulation d'un générateur (12) comprennent une horloge (40) dont la fréquence des cycles est adaptée à la durée de la polarisation électrochimique.

6. Dispositif selon l'une quelconque des revendications 1 à 5, caractérisé en ce qu'il comprend plusieurs groupes ($A_1$ ; $A_2$ ; ...$A_p$) d'anodes ($A_{11}$, $A_{12}$, ...$A_{1n}$ ; $A_{21}$, $A_{22}$, ...$A_{2n}$ ; ...$A_{p1}$, $A_{p2}$, ...$A_{pn}$) réparties en diverses zones de la structure (60) à protéger, isolées de celle-ci et en contact avec l'électrolyte (90) ; des générateurs (12) de courant continu en nombre p égal au nombre p de groupes ($A_1$ ; $A_2$ ; ...$A_p$) ; d'anodes, chaque générateur (12) étant connecté à un groupe d'anodes ($A_1$ ou $A_2$ ... ou $A_p$) ; des groupes d'électrodes de référence (1, 2) disposées au voisinage des différents groupes d'anodes ($A_1$, $A_2$, ...$A_p$) et connectées aux différents circuits de commande et de régulation (10, 20, 30..) pour ajuster la tension délivrée par chacun des générateurs (12) associés aux différents groupes d'anodes ($A_1$ ; $A_2$, ...$A_p$) ; des moyens (40, 50) pour mettre en service de façon cyclique les différents circuits de commande et de régulation (10, 20, 30) et des moyens pour affecter à chaque circuit de commande et de régulation (10, 20, 30...) des premier et second potentiels de référence ($EH_i$, $EB_i$) constituant des seuils haut et bas et pour ajuster par pas d'une valeur prédéterminée la valeur de la tension de sortie délivrée par chaque générateur (12) associé à un groupe d'anodes ($A_1$, $A_2$,... $A_p$) en fonction de la valeur de la différence de potentiel calculée par rapport aux seuils haut et bas ($EH_i$, $EB_i$).

7. Dispositif selon l'une quelconque des revendications 1 à 6, caractérisé en ce que les électrodes de référence (1, 2) sont constituées par des électrodes comprenant un réservoir d'un électrolyte saturé de manière à présenter des propriétés maintenues constantes dans le temps quelles que soient les variations de la composition de l'électrolyte (90) dans lequel est placée la structure (60) à protéger.

8. Dispositif selon la revendication 7, caractérisé en ce que le réservoir d'électrolyte d'une électrode de référence (1, 2) comprend des cristaux du sel réagissant qui sature la solution dans laquelle baigne l'électrode et en ce que la liaison entre la solution saturée et le milieu extérieur de l'électrolyte (90) s'effectue à travers un filtre poreux.

### Claims

1. Applied current cathodic protection system for a structure placed in an electrolyte, comprising at least one cathode constituted by the structure to be protected (60), at least one group $(A_1)$ of anodes $(A_{11}, A_{12}, A_{1n})$ isolated from the structure (60) and in contact with the electrolyte (90) in which said structure (60) is placed, at least one DC generator (12) connected between the cathode-forming structure (60) and the anodes $(A_{11}, ... A_{1n})$ of said group $(A_1)$ in contact with the electrolyte (90) and at least one reference electrode (1) connected to a control and regulation circuit (10) for adjusting the potential delivered by said generator (12), and consequently for adjusting the current applied to said anodes $(A_{11}, ...A_{1n})$, characterized in that it comprises means (40, 50) for bringing the circuit (10) for controlling and regulating a generator (12) into service in a cyclic manner, means (3 ; 105, 106) for reading the potential (EL11) provided by the reference electrode (1) and for calculating the potential difference between the protected structure (60) and the electrode potential as read, comparator means (6 ; 107) for comparing the calculated potential difference with a first reference potential (EH) constituting an upper threshold and with a second reference potential (EB) constituting a lower threshold, and means (9, 11 ; 108, 109) for adjusting the absolute value of output voltage delivered by the generator (12) in steps of predetermined value, in increasing direction if the calculated potential difference is less negative than that of the upper threshold (EH), or in decreasing direction if the calculated potential difference is more negative than the lower threshold (EB).

2. Device according to claim 1, characterized in that it comprises : at least two reference electrodes (1, 2) connected to the control and regulation circuit associated with the same generator (12) and to the same group of anodes, $(A_{11}, ...A_{1n})$, and in that the means (3 ; 105, 106) for reading the reference potential include a comparator circuit (3 ; 105) for determining which reference electrode (1 or 2) is the most electronegative during each cycle and for selecting the most negative potential (EL11 or EL12) for calculating the calculated potential difference.

3. Device according to claim 2, characterized in that it further comprises means (4, 5) for indicating when the difference between the potentials (EL11, EL12) of the reference electrodes (1, 2) exceeds a predetermined value.

4. Device according to any one of claims 1 to 3, characterized in that the means (40, 50) for putting the control and regulation circuit of a generator (12) into service cyclically comprise a slow-release contact (50) whose closure is functionally related to the structure (60) to be protected.

5. Device according to any one of claims 1 to 3, characterized in that the means (40, 50) for putting the control and regulation circuit of a generator (12) into service cyclically comprise a clock (40) whose cycle frequency is adapted to the duration of the electrochemical polarization.

6. Device according to any one of claims 1 to 5, characterized in that it comprises : a plurality of groups $(A_1 ; A_2 ; ...A_p)$ of anodes $(A_{11}, A_{12}, ...A_{1n} ; A_{21}, A_{22}, ... A_{2n} ; ... A_{p1}, A_{p2}, ... A_{pn})$, distributed over various zones of the structure (60) to be protected, said anodes being insulated from said structure and being in contact with the electrolyte (90) ; DC generators (12) in number p equal to the number p of groups $(A_1 ; A_2 ; ...A_p)$ of anodes, each generator (12) being connected to a group of anodes $(A_1$ or $A_2 ...$ or $A_p)$ ; groups of reference electrodes (1, 2) disposed in the vicinity of the various groups of anodes $(A_1, A_2, ... A_p)$ and connected to the different control and regulation circuits (10, 20, 30..) for adjusting the voltage delivered by each one of the generators (12) associated with the various groups of anodes $(A_1 ; A_2, ...A_p)$ ; means (40, 50) for cyclically putting into service the various control and regulation circuits (10, 20, 30) ; and means for attributing first and second reference potentials $(EH_1, EB_1)$ to each control and regulation circuit (10, 20, 30...), said first and second reference potentials constituting upper and lower thresholds, and for adjusting the value of the output voltage delivered by each generator (12) associated with a group of anodes $(A_1, A_2, ... A_p)$ in steps of predetermined size as a function of the value of the calculated potential difference relative to said upper and lower thresholds $(EH_i, EB_i)$.

7. Device according to any one of claims 1 to 6, characterized in that the reference electrodes (1, 2) are constituted by electrodes including a supply of electrolyte which is saturated in such a manner as to have properties which remain constant over time regardless of variations in the composition of the electrolyte (90) in which the structure (60) to be protected is placed.

8. Device according to claim 7, characterized in that the supply of electrolyte in a reference electrode (1, 2) comprises crystals of a reactive salt which saturate the solution in which the electrode is immersed, and wherein the saturated solution is put into communication with the external medium of electrolyte (90) via a porous filter.

**Patentansprüche**

1. Vorrichtung zum kathodischen Schützen einer Konstruktion durch Anlegen einer Spannung, bestehend aus zumindest einer Kathode, die durch die zu schützende Konstruktion (60) gebildet wird, zumindest einer Gruppe ($A_1$) von Anoden ($A_{11}$, $A_{12}$, $A_{1n}$), die von der Konstruktion (60) isoliert sind und im Kontakt mit dem Elektrolyten (90) stehen, in dem die Konstruktion (60) angeordnet ist, zumindest einer Gleichstromquelle (12), die zwischen der Konstruktion (60), die die Kathode bildet und den Anoden ($A_{11}$, ..., $A_{1n}$) der Gruppe ($A_1$), die im Kontakt mit dem Elektrolyten (90) angeordnet ist und zumindest einer Referenzelektrode (1), wobei die Referenzelektrode mit einem Regel- und Befehlskreis (10) verbunden ist, um die von der Spannungsquelle (12) gelieferte Spannung zu regeln und damit auch den an die Anoden ($A_{11}$, ..., $A_{1n}$) gelieferten Strom, dadurch gekennzeichnet, daß Mittel (40, 50) vorgesehen sind, um den Regel- und Befehlskreis (10) der Spannungsquelle (12) zyklisch zu starten, mit Potentialmeßmitteln (3 ; 105, 106), um das von der Referenzelektrode (1) stammende Potential (EL11) zu bestimmen und die Differenz zwischen dem Potential der zu schützenden Konstruktion (60) und dem Potential der Elektrode zu berechnen, mit Vergleichsmitteln (6 ; 107) um die berechnete Potentialdifferenz mit einem ersten Referenzpotential (EH), das eine obere Schranke darstellt, einerseits und einem zweiten Referenzpotential (EB), welches eine untere Schranke darstellt, andererseits zu vergleichen und mit Mitteln (9, 11 ; 108, 109), um in Schritten vorgegebener Größe die von der Spannungsquelle (12) gelieferte absolute Spannung im Sinne einer Vergrößerung zu verändern, wenn die berechnete Potentialdifferenz weniger negativ ist als die der oberen Schranke (EH) oder im Sinne einer Verkleinerung, wenn die berechnete Potentialdifferenz stärker negativ ist als die der unteren Schranke (EB).

2. Vorrichtung nach Anspruch 1, dadurch gekennzeichnet, daß sie zumindest zwei Referenzelektroden (1, 2) umfaßt, die mit dem Regel- und Befehlskreis verbunden sind, der mit derselben Spannungsquelle (12) und derselben Anodengruppe ($A_{11}$, ..., $A_{1n}$) in Verbindung steht und dadurch, daß die Mittel (3 ; 105, 106) zur Bestimmung des Referenzpotentials einen Vergleicherkreis (3 ; 105) aufweisen, um bei jedem Zyklus die Referenzelektrode (1 oder 2), die stärker elektronegativ ist, zu bestimmen und um für die Berechnung der berechneten Potentialdifferenz das negativere Potential (EL11 oder EL12) heranzuziehen.

3. Vorrichtung nach Anspruch 2, dadurch gekennzeichnet, daß weiters Mittel (4, 5) vorhanden sind, die anzeigen, wenn der Unterschied zwischen den Potentialen (EL11, EL12) der Referenzelektroden (1, 2) über einen vorbestimmten Wert steigt.

4. Vorrichtung nach einem der Ansprüche 1 bis 3, dadurch gekennzeichnet, daß die Mittel (40, 50) zur zyklischen Inbetriebnahme des Regel- und Befehlskreises einer Spannungsquelle (12) einen Verzögerungsschlter (50) aufweisen, dessen Schalten mit dem Funktionieren der zu schützenden Konstruktion (60) verbunden ist.

5. Vorrichtung nach einem der Ansprüche 1 bis 3, dadurch gekennzeichnet, daß die Mittel (40, 50) zur zyklischen Inbetriebnahme des Regel- und Befehlskreises einer Spannungsquelle (12), einen Taktkgeber (40) umfassen, dessen Frequenz der Dauer der elektrochemischen Polarisation angepaßt ist.

6. Vorrichtung nach einem der Ansprüche 1 bis 5, dadurch gekennzeichnet, daß sie mehrere Gruppen ($A_1$; $A_2$ ; ..., $A_p$) von Anoden ($A_{11}$, $A_{12}$, ..., $A_{1n}$ ; $A_{21}$, $A_{22}$..., $A_{2n}$ ; ..., $A_{p1}$, $A_{p2}$, ..., $A_{pn}$), verteilt auf verschiedene Bereiche der zu schützenden Konstruktion (60) und von dieser isoliert sowie im Kontakt mit Elektrolyt (90) aufweist, daß p Gleichstromspannungsquellen (12) vorhanden sind, wobei p eine Zahl gleich ist der Zahl p der Gruppen ($A^1$ ; $A^2$ ; ..., $A^p$) von Anoden ist, daß jede Spannungsquelle (12) mit einer Anodengruppe ($A^1$ oder $A^2$ ... oder $A^p$) verbunden ist, daß Referenzelektrodengruppen (1, 2) in der Nachbarschaft der verschiedenen Anodengruppen ($A^1$, $A^2$, ..., $A^p$) angeordnet sind und verbunden mit verschiedenen Regel- und Befehlskreisen (10, 20, 30, ...) sind, um die von jeder einzelnen Spannungsquelle (12) abgegebene Spannung zu regeln, sowie mit den verschiedenen Anodengruppen ($A^1$ ; $A^2$, ..., $A^p$) zugeordneten Mitteln (40, 50), um in zyklischer Form die verschiedenen Regel- und Befehlskreise (10, 20, 30) in Betrieb zu nehmen und mit Mitteln um jedem Regel- und Befehlskreis (10, 20, 30 ...) erste und zweite Referenzpotentiale ($EH^i$, $EB^i$) zuzuführen, die obere und untere Schranken darstellen, um in Schritten vorbestimmter Größe die Ausgangsspannung, die von jeder Spannungsquelle (12) die den einzelnen Anodengruppen ($A^1$, $A^2$, ..., $A^p$) zugeordnet ist, in Abhängigkeit vom Wert der berechneten Potentialdifferenz bezüglich der oberen und unteren Schranken ($EH^i$, $EB^i$) zu verändern.

7. Vorrichtung nach einem der Ansprüche 1 bis 6, dadurch gekennzeichnet, daß die Referenzelektroden (1, 2) aus Elektroden bestehen, die einen Behälter mit gesättigtem Elektrolyt aufweisen, um konstante Eigenschaften aufrecht zu erhalten, unabhängig von den Veränderungen der Zusammensetzung des Elektrolyten (90), in dem die zu schützende Konstruktion (80) angeordnet ist.

8. Vorrichtung nach Anspruch 7, dadurch gekennzeichnet, daß der Elektrolytbehälter der Referenzelektrode (1, 2) Salzkristalle enthält, die so reagieren können, daß sie die Lösung, von der die Elektrode umspült ist, sättigen, und daß die Verbindung zwischen der gesättigten Lösung und der äußeren Umgebung des Elektrolyten (90) durch ein poröses Filter erfolgt.

Fig. 1

Fig. 4

Fig. 2

Fig. 3

```
        ┌─────────────────┐
        │   REGULATION    │──── 101
        └─────────────────┘
                 │
        ┌─────────────────────────┐
        │ FREQUENCE DE SCRUTATION │──── 102
        └─────────────────────────┘
                 │
        ┌────────────────────────┐
        │  LECTURE DES SEUILS    │──── 103
        │   HAUT ET BAS          │
        └────────────────────────┘
                 │
        ┌──────────────────────────┐
        │ ACQUISITION DES COUPLES  │──── 104
        │ DE POTENTIELS D'ELECTRODE│
        └──────────────────────────┘
                 │
        ┌──────────────────────────┐
        │ CHOIX DE L'ELECTRODE     │──── 105
        │ A POTENTIEL LE PLUS BAS  │
        └──────────────────────────┘
                 │
        ┌──────────────────────────┐
        │ CALCUL DE LA DIFFERENCE  │
        │ DE POTENTIEL ENTRE STRUCTURE│──── 106
        │ PROTEGEE ET POTENTIEL    │
        │ D'ELECTRODE              │
        └──────────────────────────┘
                 │
             107 ◇
    COMPARAISON AVEC LES SEUILS
           Haut et Bas
```

Seuil haut

Seuil bas

Entre seuil haut et bas.

108

DIMINUER LE GENERATEUR D'UN PAS

109

AUGMENTER LE GENERATEUR D'UN PAS

110

FIN DE BOUCLE DE GROUPE

Non

Oui

111

FIN DE BOUCLE SCRUTATION

Non

Oui

FIN ──112